# DEMANDE DE BREVET EUROPEEN

(11) **EP 1 041 625 A1**
(43) Date de publication de la demande: **04.10.2000**
(21) Numéro de dépôt: 00420048.1
(22) Date de dépôt: 23.03.2000
(51) Int. Cl.: H01L 23/10, H01L 23/488

(54) **Composant électrique ou électronique encapsulé de maniere étanche et procédé pour sa réalisation**

(30) Priorité: 31.03.1999 FR 9904219
(71) Demandeur: SOCIETE FRANCAISE DE DETECTEURS, INFRAROUGES- SOFRADIR, F-92290 Chatenay Malabry (FR)
(72) Inventeur: Salaville, André, 38000 Grenoble (FR)
(74) Mandataire: Vuillermoz, Bruno

(57) **Abrégé**

Ce composant électrique ou électronique à encapsulation étanche comprend :
- un support (1), destiné à recevoir un ou plusieurs composants électriques ou électroniques (5), à partir du ou desquels rayonnent des pistes électriquement conductrices (6) en direction de la périphérie dudit support ;
- et un boîtier (2) de protection et d'étanchéité rapporté sur ledit support, et scellé hermétiquement à celui-ci au moyen d'un cordon métallique périphérique (7), la partie principale dudit boîtier, destinée à venir en regard dudit support (1), étant munie d'éléments conducteurs creux (3), traversant de part en part son épaisseur, et à partir de l'extrémité supérieure externe desquels rayonnent des pistes métalliques conductrices de l'électricité (9) en direction de la périphérie du boîtier, et dont l'extrémité inférieure interne est connectée à au moins une piste de connexion électrique (6) ménagée sur ledit support par l'intermédiaire d'une bille métallique d'hybridation (8).

## Description

L'invention concerne un nouveau composant électrique ou électronique, muni d'un système d'encapsulation étanche. Elle concerne également le procédé permettant sa réalisation.

Le domaine de l'invention a donc plus particulièrement trait aux composants et micro-composants, également dénommés puces électroniques, mais également aux micro-capteurs, micro-actuateurs, etc. .

Ces micro-composants sont classiquement déposés sur un substrat de nature appropriée, par exemple de type semi-conducteur (silicium monocristallin, saphir, etc..) pour les composants électroniques. Un certain nombre de pistes conductrices de l'électricité rayonnent à partir de ce micro-composant, en direction de la périphérie du substrat, afin de permettre outre l'alimentation électrique du composant le cas échéant requise, également le traitement et l'exploitation des signaux qu'il est appelé à générer, ou encore le pilotage des fonctions qu'il incorpore. On adjoint quelque fois à ce composant un boîtier ou capot de protection, propre à éviter les écueils inhérents aux chocs, à la corrosion, aux rayonnements électro-magnétiques parasites, etc, ledit capot étant rapporté par exemple par collage Ce capot peut en outre intégrer une fenêtre transparente à un rayonnement à détecter par ledit composant, ou encore une lentille de concentration dudit rayonnement au niveau du composant.

Certains de ces micro-composants nécessitent pour leur fonctionnement, de travailler sous vide ou sous atmosphère contrôlée (pression, gaz neutre(s), etc...), ou de manière étanche par rapport à l'atmosphère ambiante. De fait, on met à contribution le boîtier ou capot précité, afin de définir une cavité au dessus dudit composant, renfermant l'atmosphère contrôlée adéquate ou le vide. Deux préoccupations techniques sont donc à prendre en considération :
- tout d'abord, le caractère hermétique de la liaison capot - composant, destiné à isoler ledit composant des agents extérieurs, indépendamment de la nature de l'atmosphère alors emprisonnée dans le volume ainsi défini ;
- ensuite, la nature contrôlée de l'atmosphère confinée dans ledit volume, imposant que cette atmosphère soit communiquée au sein de ce volume préalablement au scellement du capot sur le composant.

Diverses techniques ont à ce jour été mises en oeuvre pour permettre ainsi l'encapsulation étanche dudit composant électronique. Parmi celles-ci, telles que par exemple décrites dans les documents WO 95/17014 et GB-A-2 310 952, figure la mise en oeuvre d'un capot ou couvercle, aligné avec le support muni de son composant électronique, et que l'on vient souder sur toute la périphérie dudit support. Cette soudure ou ce scellement s'effectue classiquement par jonction métal/métal, mettant typiquement en oeuvre un joint de soudure réalisé en indium ou en alliage étain/plomb.

Traditionnellement, cette technique s'effectue en plusieurs étapes : elle consiste à aligner le capot sur le composant, le tout au sein d'une enceinte propre à assurer une atmosphère contrôlée, ou au contraire, une enceinte sous vide, fonction de l'atmosphère souhaitée, puis à sceller ledit capot sur le composant selon des technologies parfaitement connues de l'homme du métier.

On conçoit aisément que, dès lors qu'une multiplicité de ces opérations doit être effectuée ou que l'on mette en oeuvre un support multi-composants, l'installation destinée à assurer ces opérations devient très complexe et très lourde à mettre en oeuvre, attendu que l'ensemble de ces opérations doit être opéré au sein de l'enceinte assurant comme déjà dit, le maintien de l'atmosphère contrôlée ou le maintien sous vide.

La réalisation de tels micro-composants fait de plus en plus souvent appel aux techniques proches de la micro-électronique, lesdits composants étant élaborés de manière collective. Cependant, ces micro-composants remplissent des fonctions de plus en plus élaborées et complexes, nécessitant une augmentation corollaire de la connectique destinée à permettre leur exploitation.

En effet, ces micro-composants nécessitent un nombre important d'entrées et de sorties électriques, afin de permettre d'assurer d'une part, leur fonctionnement et d'autre part, l'exploitation de leurs effets. Ce nombre d'entrées et de sorties nécessite un nombre égal de pistes de conduction électrique, pistes qui vont en s'élargissant en direction de la périphérie du support, en raison d'un nombre correspondant de plots de connexion vers l'extérieur, conduisant de la sorte à un accroissement considérable de la surface occupée par la seule connectique. Paradoxalement, les progrès de la micro-électronique permettent de réduire la partie active du composant proprement dit. En d'autres termes, une partie significative de la matière noble et donc coûteuse mise en jeu, à savoir le substrat portant le composant, est affectée à la seule fin de recevoir les pistes de connectique.

Dès lors, il se conçoit aisément que la fabrication collective perd de son efficacité, et que dans certains cas l'abondance de la connectique ne permet plus de la réaliser sur un seul niveau. De plus, lorsqu'un boîtier soudé est requis, la connectique doit être protégée du cordon de soudure par la mise en oeuvre d'une couche isolante, généralement dénommée passivation.

Afin de faire face à cette augmentation de la connectique, on a proposé la réalisation de l'empilement de plusieurs niveaux de connectique en séparant lesdits niveaux d'une couche isolante de passivation. Cependant, si cette technique de passivation permet de résoudre le problème au niveau immédiat du composant proprement dit, elle ne peut bien entendu concerner les plots de soudure destinés à assurer les connexions extérieures. En outre, quand bien même cette technique de passivation est relativement bien maîtrisée, elle n'en présente pas moins un certain nombre de déficiences, telles que fuites, court - circuits, etc., affectant les rendements. Enfin et surtout, elle induit la mise en oeuvre d'étapes supplémentaires lors de la réalisation des micro-composants, et en outre génère un plus grand nombre de pertes, puisqu'à chaque étape est associé un pourcentage de pertes non négligeables, affectant de fait le coût global de la réalisation de tels micro-composants.

On a également proposé, toujours dans l'objectif de répondre à cette augmentation de la connectique, de transférer au niveau du capot ou boîtier de protection partie au moins de cette connectique. Ainsi, dans le document EP-A-0 609 062, le capot comporte plusieurs pistes conductrices réalisées au niveau de sa face externe, et reliées électriquement au composant électronique situé à l'intérieur du volume défini par l'ensemble support + capot, par des traversées conductrices. Ces traversées conductrices s'étendent au sein de l'épaisseur dudit capot et sont pleines, de telle sorte à assurer l'étanchéité au sein du volume précité.

De fait, si par ce moyen il devient possible d'augmenter la connectique, le problème lié au confinement d'une atmosphère contrôlée ou du vide au sein du volume défini par l'ensemble support + capot demeure entier, notamment en termes de simplicité de l'installation, et partant du prix de revient des composants ainsi réalisés. On retrouve en effet les inconvénients liés au capot mis en oeuvre dans le document WO 9517014.

L'objectif de la présente invention est de répondre à ces deux problèmes principaux en proposant un dispositif et une technologie susceptibles d'augmenter significativement la capacité de connectique du composant, notamment pour les cas où les contraintes d'environnement sévères l'imposent, tout en permettant une encapsulation efficace dudit composant. Elle vise en outre, à titre secondaire, à supprimer la nécessité d'une passivation. Cependant, dans les cas d'un fort besoin de connectique, l'invention permet tout à la fois de disposer d'un niveau de connectique standard sur le substrat, dans cette hypothèse passivé, et d'un second niveau de connectique sur le boîtier.

Ce composant électrique ou électronique à encapsulation étanche comprend :
- un support destiné à recevoir un ou plusieurs composants électriques ou électroniques, à partir du ou desquels rayonnent des pistes électriquement conductrices en direction de la périphérie dudit support ;
- et un boîtier de protection et/ou d'étanchéité rapporté sur ledit support, et scellé hermétiquement à celui-ci au moyen d'un cordon métallique périphérique, la partie principale dudit boîtier, destinée à venir en regard dudit support, étant munie de conducteurs traversant creux de part en part son épaisseur, à partir de l'extrémité supérieure (externe) desquels rayonnent des pistes métalliques conductrices de l'électricité en direction de la périphérie du boîtier, et dont l'extrémité inférieure interne (par rapport au boîtier) est connectée à au moins une piste de connexion électrique ménagée sur ledit support par l'intermédiaire d'une bille métallique de brasure par hybridation.

En d'autres termes, l'un des aspects de l'invention consiste à répartir tout ou partie de la connectique sur la face supérieure et donc externe du capot ou boîtier, le transfert de cette connectique de la surface du micro-composant au boîtier étant assuré par des micro-billes, notamment d'indium ou d'alliage étain/plomb, selon la technique connue de l'hybridation.

L'hybridation au moyen de micro-billes fusibles, généralement réalisée en indium ou en alliage plomb/étain, est bien connue pour la réalisation de contacts électriques collectifs de composants électriques, que ceux-ci développent des fonctions similaires (empilement de circuits silicium) ou au contraire fort différentes (composants de détection sur circuit de lecture, par exemple dans le cadre des détecteurs infra-rouge).

Cependant, cette technique n'a jamais été mise en oeuvre pour la mise en place d'un boîtier de protection muni de traversées conductrices pleines et étanches, suffisantes lorsque seule l'herméticité est recherchée en conjonction avec la réalisation d'un niveau de connectique supérieure sur le boîtier, ou de plots ou trous métallisés, libérant un accès pour l'acheminement de l'atmosphère contrôlée dans la cavité ainsi définie, lorsqu'en outre, elle s'accompagne simultanément de la réalisation d'une telle atmosphère contrôlée par la fusion d'un cordon de soudure périphérique.

Selon une caractéristique avantageuse de l'invention, les billes métalliques de brasure sont réalisées dans le même matériau que le cordon de soudure périphérique.

Selon une autre caractéristique de l'invention, les éléments conducteurs ménagés au travers de la partie principale du boîtier sont exclusivement constitués d'orifices traversants métallisés, dont la base inférieure est destinée à entrer en contact intime pour brasure hermétique avec lesdites billes ou micro-billes, après fusion du cordon de soudure périphérique. Cette forme de réalisation présente ainsi l'avantage d'établir avant scellement dudit boîtier sur le support, une atmosphère contrôlée ou le vide au sein de la cavité définie par le boîtier et le support, l'extrémité inférieure desdits orifices traversants n'étant pas en contact avec les billes de brasure avant scellement.

Selon l'invention, le boîtier ou capot peut être équipé selon le cas d'une fenêtre transparente, voire d'une lentille de concentration du rayonnement, ou de tout autre organe susceptible de remplir une fonction technique simple.

L'invention concerne également le procédé pour la réalisation d'un tel composant.

Ce procédé consiste :
- tout d'abord à mettre en place au niveau d'un support comportant un composant électrique ou électronique muni de pistes conductrices de l'électricité rayonnantes en direction de sa périphérie, un cordon de scellement continu réalisé en un métal ou un alliage métallique à faible température de fusion, tout ou partie desdites pistes s'arrêtant avant d'atteindre ledit cordon ;
- puis, au niveau de l'extrémité desdites pistes conductrices, à mettre en place des micro-billes, réalisées en un matériau métallique, de diamètre inférieur au diamètre ou à l'épaisseur dudit cordon ;
- puis à positionner sur le support ainsi réalisé, un boîtier ou capot de dimensions appropriées, dont la face supérieure, destinée à venir en regard dudit support est munie d'éléments conducteurs creux, traversant ladite face de part en part, et situés à l'aplomb desdites micro-billes et est pourvue de pistes métalliques conductrices s'étendant à partir de l'extrémité supérieure desdits éléments conducteurs en direction de la périphérie dudit capot, ledit capot reposant sur le cordon de scellement périphérique ;
- et enfin, à élever la température de l'enceinte au sein de laquelle est positionné l'ensemble ainsi constitué afin de provoquer la fusion des matériaux constitutifs du cordon de scellement périphérique et des micro-billes, induisant d'une part, l'abaissement dudit capot en direction du support et corollairement son scellement périphérique étanche et hermétique audit support propre à assurer l'étanchéité périphérique du volume interne ainsi défini vis à vis de l'extérieur, et d'autre part, la soudure desdites microbilles au niveau de l'extrémité inférieure des éléments conducteurs traversants, de telle sorte à réaliser la continuité électrique entre les pistes conductrices du support et celles du capot ou boîtier et l'étanchéité du volume ainsi défini.

Avantageusement, les éléments conducteurs traversants creux sont constitués d'orifices traversants métallisés, et l'élévation de température au sein de l'enceinte induit la fusion et la brasure étanche et hermétique de chacune des micro-billes au sein desdits orifices.

La manière dont l'invention peut être réalisée et les avantages qui en découlent ressortiront mieux de l'exemple de réalisation qui suit ; donné à titre indicatif et non limitatif à l'appui des figures annexées.

La figure 1 est une représentation schématique en perspective et en éclatée des éléments entrant dans la composition du composant conforme à l'invention préalablement à l'opération de scellement.

La figure 2 est une vue schématique du dessus du composant conforme à l'invention. La figure 3 est une vue en section transversale de l'étape préalable de préparation à l'opération de soudure.

La figure 4 est une vue analogue lorsque les opérations de scellement sont terminées. La figure 5 est une représentation schématique en perspective de l'ensemble boîtier-support obtenu après scellement.

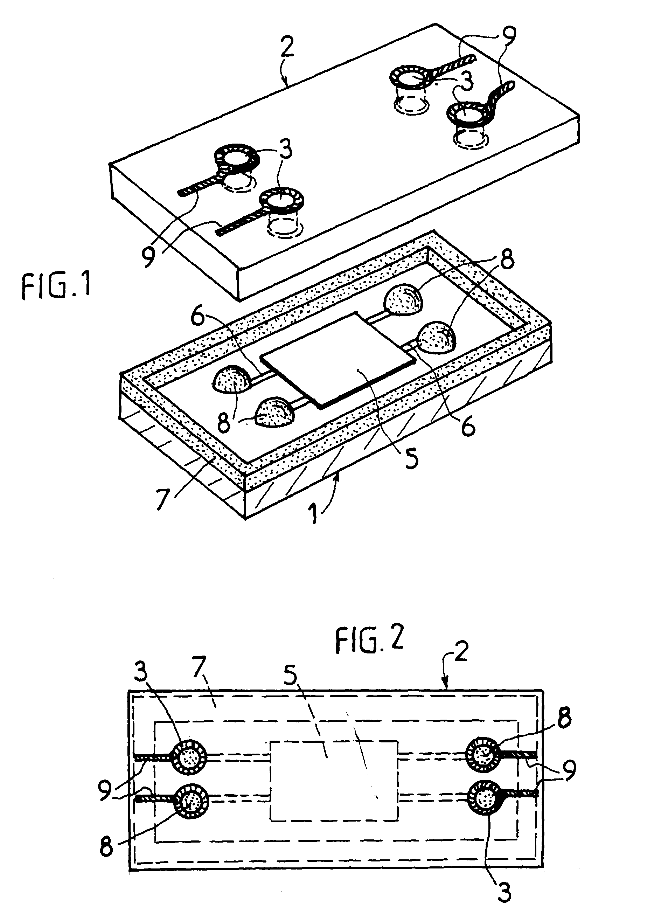

On a représenté schématiquement sur la figure 1 une vue éclatée en perspective d'un composant conforme à l'invention préalablement à sa réalisation définitive, c'est à dire préalablement à l'assemblage d'un capot ou boîtier de protection (2) sur un support (1), et dans laquelle une atmosphère contrôlée ou le vide est nécessaire pour le bon fonctionnement dudit composant.

Ce support (1) est constitué d'un substrat, réalisé en silicium par exemple, voire en alumine ou tout autre matériau traditionnel pour l'assemblage des micro-composants, sur la face supérieure duquel est mis en place un composant électrique ou électronique (5), dont les fonctions peuvent être multiples. Il peut par exemple s'agir d'un capteur ou micro-capteur, notamment de rayonnement, mais également d'un accéléromètre, d'un bolomètre, d'activateurs ou de micro-activateurs, etc..

Comme on le sait, le fonctionnement et l'exploitation de ces composants nécessitent l'acheminement et le traitement de signaux électriques, lesdits signaux transitant par le biais de pistes conductrices électriques (6) s'étendant depuis l'implantation du composant sur le substrat en direction de la périphérie dudit support (1).

En outre, il est souvent préférable de protéger ces composants des influences extérieures et certains d'entre eux nécessitent même impérativement de fonctionner sous atmosphère contrôlée et par exemple, sous des pressions spécifiques voire en présence d'un gaz inerte ou d'un gaz spécifique ou, encore doivent fonctionner sous vide, tels que les composants refroidis.

Pour ce faire, le support (1) est surmonté d'un capot ou boîtier (2), scellé hermétiquement au support (1) et définissant ainsi une cavité (4), isolée de l'extérieur et présentant les caractéristiques propres à permettre le fonctionnement du composant (5).

Ce boîtier (2) peut être muni d'une fenêtre (non représentée), transparente et notamment transparente à certains rayonnements tels que par exemple l'infrarouge lorsque le composant (5) est un détecteur infrarouge. Cette fenêtre peut même être constituée d'une lentille propre à concentrer au niveau du composant (5) le rayonnement ainsi capté.

La fixation du boîtier (2) sur le support (1) s'effectue en mettant en oeuvre une technologie connue de soudure métal/métal, faisant appel à un joint ou cordon périphérique continu (7), typiquement réalisé en indium ou encore en alliage étain/plomb, ou tout alliage de brasure basse température.

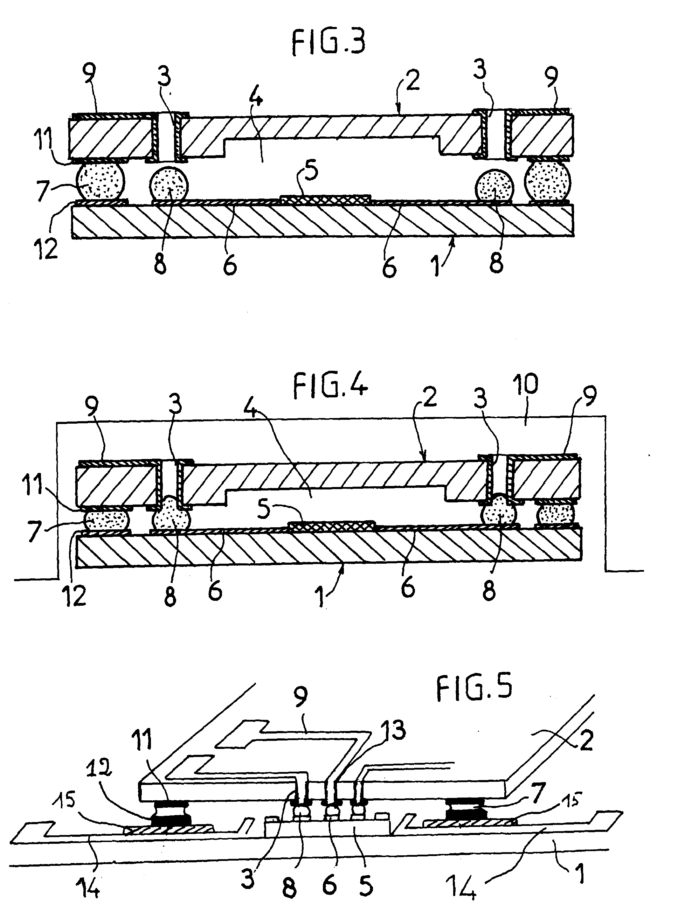

A cet effet, ce cordon est déposé sur une plage de mouillabilité (12), que l'on a représenté au niveau des figures 3 et 4, par exemple réalisée à base d'un empilement tri-couches titane/nickel/or, effectué par exemple par dépôt et photolithographie, ou tout autre empilement métallique en couches minces, classique dans le domaine de la micro-électronique.

Les mêmes plages de mouillabilité (11) sont également présentes sur le boîtier au niveau de sa face inférieure, disposées bien entendu en regard du cordon (7). Elles sont éventuellement réalisées de la même manière et dans le même matériau, bien que cette caractéristique ne revête aucun caractère impératif.

Le boîtier (2) est réalisé en un matériau électriquement isolant, voire semi-conducteur, tel que le silicium ou germanium.

Selon une première forme de réalisation de l'invention, la face inférieure (interne) de la partie principale du boîtier (2), destinée à venir en regard du support (1), est munie d'orifices traversants creux (3), dont la surface interne est métallisée, afin de permettre la conduction de l'électricité, la métallisation débordant en outre légèrement au niveau de la face interne dudit boîtier, ainsi qu'on peut bien l'observer sur les figures 3 et 4. La localisation de ces orifices traversants est ménagée de telle sorte qu'ils soient situés à l'aplomb du voisinage de l'extrémité des pistes métalliques conductrices (6) réalisées au niveau du support (1). Plus précisément, ces orifices métallisés (3) sont destinés à coopérer avec des micro-billes (8) réalisées, par exemple, dans le même matériau que le matériau constitutif du cordon de scellement (7).

L'extrémité supérieure des orifices traversants (3) au niveau de la surface externe de ladite partie principale du boîtier est en contact intime avec le départ de pistes conductrices métalliques (9), ainsi qu'on peut bien l'observer sur les figures 1 et 2, lesdites pistes s'étendant en particulier en direction de la périphérie dudit boîtier, jusqu'à atteindre des plots de connexion.

De la sorte, le boîtier (2), outre son rôle de protection, et également, en coopération avec le support (1), de définition d'une cavité (4) étanche et susceptible de renfermer soit une atmosphère contrôlée, soit le vide, constitue un relais de connectique plus particulièrement appréciable lors de la mise en oeuvre de micro-composants (5) nécessitant une connectique complexe.

On a représenté en figure 3 l'étape de réalisation d'un composant conforme à l'invention, consécutive à l'étape représentée sur la figure 1. Dans celle-ci, le boîtier (2) est positionné sur le support (1) et repose par le biais de la plage de mouillabilité (11) sur le cordon de scellement (7) préalablement disposé au niveau du support (1).

Cette étape de positionnement s'effectue de manière rigoureuse, de telle sorte à faire coïncider les orifices traversants (3) avec les micro-billes (8). A cet égard, il doit être observé que le diamètre de ces micro-billes est inférieur au diamètre ou à l'épaisseur du cordon de scellement (7). En outre, quand bien même celui-ci a été représenté schématiquement selon une section transversale carrée ou rectangulaire sur la figure 1, il peut également être de section sensiblement circulaire ou semi-circulaire.

L'opération de positionnement s'effectue soit automatiquement, au moyen d'une installation appropriée, connue sous l'appellation machine de brasure « flip-chip », soit manuellement. Une fois cette opération réalisée, soit une enceinte (10) est amenée sur le ou les composants, soit celui-ci ou ceux-ci sont amenés au sein de l'enceinte. Selon une autre alternative, le positionnement a été réalisé au sein cette enceinte (10). Quoiqu'il en soit, cette enceinte (10) est fermée et, l'atmosphère souhaitée au sein de la cavité (4) est réalisée, c'est à dire soit atmosphère contrôlée, soit au contraire le vide poussé.

Il est alors procédé à une élévation de température au sein de l'enceinte (10), suffisante pour induire la fusion du ou des matériaux constitutifs respectivement du cordon de scellement (7) et des micro-billes (8). Les dimensions respectives du cordon (7) et des micro-billes (8) ainsi que celles des plages de mouillabilité, notamment (11) et (12), sont choisies de telle sorte que cette fusion entraîne un abaissement du capot ou boîtier (2) en direction du support (1), suffisant pour engendrer d'une part le contact des micro-billes fondues (8) avec la métallisation réalisée au sein des orifices traversants (3), et d'autre part la soudure desdites micro-billes (8) aux orifices (3), ainsi que par ailleurs on peut bien l'observer au sein de la figure 4.

On obtient de la sorte, outre une soudure étanche et efficace entre le boîtier (2) et le support (1) au niveau du cordon (7), ainsi qu'au niveau des microbilles (8), également une continuité électrique entre les pistes (6) du support (1) et les pistes (9) du boîtier (2), permettant ainsi un fonctionnement efficace du composant (5).

On a représenté sur la figure 5 des pistes conductrices (14) débordant du capot, ainsi que la couche de passivation (15) alors nécessaire.

On conçoit donc aisément tous les avantages de l'invention dans la mesure où, outre la possibilité de s'affranchir de l'étape supplémentaire de passivation décrite en préambule, attendu que toute la connectique au niveau du support (1) peut être disposée en retrait du cordon de scellement, on bénéficie surtout d'un étage supplémentaire de connectique, permettant ainsi de sauvegarder de la matière noble (le support (1)) tout en permettant d'augmenter la complexité du composant proprement dit. Ce faisant, on optimise une nouvelle fois la diminution de la taille de ces composants.

Il convient surtout de souligner que le procédé conforme à l'invention permet de réaliser deux fonctions, respectivement la fermeture étanche du composant, et la mise en oeuvre d'un second étage de connectique, en une seule opération, de par la mise en oeuvre d'orifices traversants creux et métallisés, générant en outre, un gain de temps et une simplification des opérations.

Selon l'invention, un ou plusieurs dispositifs getters bien connus peuvent être positionnés dans la cavité quand celle-ci est sous vide.

A titre surabondant, la taille du dispositif intégral peut être très proche de la taille du composant actif, optimisant de la sorte le gain de place par diminution de l'encombrement.

## Revendications

1. Composant électrique ou électronique à encapsulation étanche comprenant :
• un support (1), destiné à recevoir un ou plusieurs composants électriques ou électroniques (5), à partir du ou desquels rayonnent des pistes électriquement conductrices (6) en direction de la périphérie dudit support ;
• et un boîtier (2) de protection et d'étanchéité rapporté sur ledit support, et scellé hermétiquement à celui-ci au moyen d'un cordon métallique périphérique (7), la partie principale du boîtier, destinée à venir en regard dudit support (1), étant munie d'éléments conducteurs creux (3), traversant de part en part l'épaisseur dudit boîtier, et à partir de l'extrémité supérieure externe desquels rayonnent des pistes métalliques conductrices de l'électricité (9) en direction de la périphérie du boîtier, et dont l'extrémité inférieure interne est connectée à au moins une piste de connexion électrique (6) ménagée sur ledit support par l'intermédiaire d'une bille métallique d'hybridation (8).

2. Composant électrique ou électronique à encapsulation étanche selon la revendication 1, ***caractérisé*** en ce que les éléments conducteurs creux ménagés au travers de l'épaisseur de la partie principale du boîtier (2) sont constitués d'orifices traversants métallisés (3), dont la base inférieure interne est brasée hermétiquement avec lesdites billes ou micro-billes (8).

3. Composant électrique ou électronique selon l'une des revendications 1 et 2, ***caractérisé*** en ce que les billes métalliques d'hybridation sont réalisées dans le même matériau que le cordon de scellement périphérique (7).

4. Composant électrique ou électronique à encapsulation étanche selon l'une des revendications 1 à 3, ***caractérisé*** en ce que le boîtier ou capot (2) est équipé selon le cas d'une fenêtre transparente, voire d'une lentille de concentration du rayonnement, ou de tout autre organe susceptible de remplir une fonction technique simple.

5. Composant électrique ou électronique à encapsulation étanche selon l'une des revendications 1 à 4, ***caractérisé*** en ce que les matériaux constitutifs du cordon de scellement (7) et des billes ou micro-billes d'hybridation sont choisis dans le groupe comprenant l'indium, les alliages étain/plomb, les métaux et alliages fusibles dédiés aux techniques de brasure basse température.

6. Procédé pour la réalisation d'un composant électrique ou électronique à encapsulation étanche, ***caractérisé*** en ce qu'il consiste :
• tout d'abord à mettre en place au niveau d'un support (1) comportant un composant électrique ou électronique (5) muni de pistes (6) conductrices de l'électricité rayonnantes en direction de sa périphérie, un cordon de scellement continu (7), réalisé en un métal ou un alliage métallique à faible température de fusion, tout ou partie desdites pistes (6) s'arrêtant avant d'atteindre ledit cordon (7);
• puis, au niveau de l'extrémité de toute ou partie de chacune des pistes conductrices (6), à mettre en place des micro-billes (8), réalisées en un métal ou un alliage à bas point de fusion, identique ou non au matériau constitutif dudit cordon, et de diamètre inférieur au diamètre ou à l'épaisseur de celui-ci ;
• puis à positionner sur le support (1) ainsi réalisé, un boîtier ou capot (2) de dimensions appropriées, dont la face interne de la partie principale, destinée à venir en regard dudit support est munie d'éléments conducteurs creux (3), traversant l'épaisseur de ladite partie principale de part en part, et situés à l'aplomb desdites micro-billes (8), ledit boîtier étant pourvu de pistes métalliques (9) conductrices de l'électricité, s'étendant à partir de l'extrémité supérieure desdits éléments conducteurs en direction de la périphérie dudit capot, ledit capot reposant sur le cordon de scellement périphérique (7) ;
• et enfin, à élever la température au sein de l'enceinte (10) dans laquelle est positionné l'ensemble ainsi constitué afin de provoquer la fusion des matériaux constitutifs du cordon de scellement périphérique (7) et des micro-billes (8), induisant d'une part, l'abaissement dudit capot ou boîtier (2) en direction du support (1) et corollairement son scellement étanche et hermétique audit support propre à assurer l'étanchéité du volume interne (4) ainsi défini vis à vis de l'extérieur, et d'autre part, la brasure desdites microbilles (8) au niveau de l'extrémité inférieure des éléments conducteurs traversants (3), de telle sorte à réaliser la continuité électrique entre les pistes conductrices (6) du support (1) et celles (9) du capot ou boîtier (2) et l'étanchéité du volume interne (4) ainsi défini.

7. Procédé pour la réalisation d'un composant électrique ou électronique à encapsulation étanche selon la revendication 6, ***caractérisé*** en ce que les éléments conducteurs creux traversants sont constitués d'orifices traversants métallisés (3), et en ce que l'élévation de température au sein de l'enceinte (10) induit la fusion de chacune des micro-billes (8) au sein desdits orifices (3) et la brasure hermétique à la métallisation de ces orifices.

8. Procédé pour la réalisation d'un composant électrique ou électronique à encapsulation étanche selon l'une des revendications 6 et 7, ***caractérisé*** en ce que l'on dispose sur le support (1) et la face intérieure du boîtier ou capot (2) des couches métalliques faisant office de plages de mouillabilité (11, 12), à l'aplomb de la zone de réception du cordon de scellement (7) et des microbilles (8).
